# FASCICULE DE BREVET EUROPEEN

(11) **EP 4 303 175 B1**
(45) Date de publication et mention de la délivrance du brevet: **16.09.2026**
(21) Numéro de dépôt: 23183245.2
(22) Date de dépôt: 04.07.2023
(51) Int. Cl.: B81C 1/00

(54) **PROCEDE DE FABRICATION D'UNE STRUCTURE COMPRENANT UNE PLURALITÉ DE MEMBRANES SURPLOMBANT DES CAVITES**
VERFAHREN ZUR HERSTELLUNG EINER STRUKTUR MIT EINER VIELZAHL VON MEMBRANEN, DIE ÜBER HOHLRÄUME ÜBERLEITEN
METHOD FOR MANUFACTURING A STRUCTURE COMPRISING A PLURALITY OF MEMBRANES OVERHANGING CAVITIES

(30) Priorité: 08.07.2022 FR 2207032
(43) Date de publication de la demande: 10.01.2024
(73) Titulaire: SOITEC, 38190 Bernin (FR); Commissariat à l'Energie Atomique et aux Energies Alternatives, 75015 Paris (FR)
(72) Inventeur: GHYSELEN, Bruno, 38190 BERNIN (FR); SALVETAT, Thierry, 38054 GRENOBLE CEDEX 9 (FR); BERRE, Guillaume, 38054 GRENOBLE CEDEX 9 (FR); RIEUTORD, François, 38054 GRENOBLE CEDEX 9 (FR)
(74) Mandataire: IP Trust

(56) Documents cités:
- WO-A1-2021/032927

## Description

### DOMAINE DE L'INVENTION

La présente invention vise le domaine de la microélectronique et des microsystèmes électromécaniques. En particulier, la présente invention concerne un procédé de fabrication collective d'une pluralité de membranes surplombant et scellant des cavités, au sein d'une structure comprenant un substrat support et une couche mince (cette dernière composant les membranes), les cavités étant confinées entre le substrat support et une face de la couche mince.

### ARRIÈRE PLAN TECHNOLOGIQUE DE L'INVENTION

Les dispositifs MEMS (« Microelectromechanical systems » selon la terminologie anglo-saxonne) sont largement utilisés pour la fabrication de capteurs divers, visant une multitude d'applications : on peut citer par exemple, les capteurs de pression, les microphones, les interrupteurs radiofréquences, les transducteurs électro-acoustiques et ultrasonores (par exemple pMUT « Piezoelectric Micromachined Ultrasonic Transducer »), etc. Beaucoup de ces dispositifs MEMS sont basés sur une membrane flexible surplombant une cavité. En fonctionnement, le fléchissement de la membrane, lié à un paramètre physique (par exemple la propagation d'une onde acoustique pour un pMUT), est converti en un signal électrique (ou vice-versa selon que le dispositif est en mode récepteur ou émetteur).

Il existe plusieurs procédés de transfert de couche permettant d'obtenir une structure comprenant une pluralité de membranes surplombant chacune une cavité. Ils sont avantageusement basés sur un assemblage par collage direct (c'est-à-dire sans ajout de matière adhésive) d'un substrat donneur et d'un substrat support, au niveau de leurs faces avant respectives. L'un ou l'autre des substrats comprend des cavités débouchant du côté de sa face avant, habituellement le substrat support. Ces cavités sont scellées lors de l'étape d'assemblage par adhésion moléculaire des deux substrats. Une étape d'amincissement du substrat donneur donne lieu au transfert d'une couche mince sur le substrat support. Cette étape d'amincissement peut consister en un amincissement mécanique, chimique ou mécano-chimique du substrat donneur, lequel peut éventuellement comprendre une ou plusieurs couche(s) d'arrêt enterrée(s) pour favoriser l'obtention d'une couche mince uniforme.

Elle peut également être basée sur le procédé Smart Cut^{™} lequel met en œuvre un plan fragile enterré, formé par implantation d'espèces légères dans le substrat donneur, qui délimite, avec une face avant du substrat donneur, la couche mince à transférer; comme cela est bien connu en soi, la croissance de microfissures dans le plan fragile enterré, par activation thermique et/ou mécanique, conduit à une séparation le long dudit plan qui donne lieu au transfert de la couche mince sur le substrat support. Le reste du substrat donneur peut être réutilisé pour un transfert de couche ultérieur.

L'étape d'amincissement peut encore faire appel à un substrat donneur démontable, c'est-à-dire comprenant la couche mince à transférer associée à un substrat temporaire via une interface ou une couche démontable ; on pourra notamment citer une interface de collage rugosifiée, une couche poreuse ou autre interface/couche autorisant un démontage. Après assemblage par collage direct dudit substrat donneur sur le substrat support, une sollicitation thermique, chimique et/ou mécanique permet d'obtenir une séparation au niveau de l'interface ou couche démontable, donnant lieu au transfert de la couche mince sur le substrat support, le substrat temporaire pouvant potentiellement être réutilisé pour un transfert de couche mince ultérieur.

Après transfert de la couche mince sur le substrat support, il est habituellement observé que les membranes à l'aplomb des cavités présentent une déformation, positive ou négative (selon un axe normal au plan de la face avant du substrat support), non identique entre la pluralité des membranes. La variabilité de ces déformations peut complexifier ou rendre inhomogènes des étapes technologiques ultérieures, requises pour la fabrication des dispositifs MEMS ; elle peut également générer des comportements électromécaniques variables entre les membranes de la structure, affectant la performance des dispositifs ou leur rendement de fabrication.

Le document FR3100081 propose un procédé de scellement d'une pluralité de cavités par des membranes permettant de réduire le différentiel de déformation de ces dernières.

Au-delà d'une réduction de la variabilité de déformation, il apparaît intéressant de viser une déformation des membranes aussi faible que possible, sur toute l'étendue de la structure.

### OBJET DE L'INVENTION

La présente invention propose un procédé de fabrication collective d'une pluralité de membranes surplombant et scellant des cavités, au sein d'une structure comprenant un substrat support et une couche mince (cette dernière composant les membranes), les cavités étant délimitées entre une face du substrat support et une face de la couche mince, et les membranes présentant une déformation minimale voire nulle sur toute l'étendue de la structure.

### BREVE DESCRIPTION DE L'INVENTION

La présente invention définit un procédé de fabrication d'une structure selon la revendication 1, et un procédé de fabrication d'une structure selon la revendication 6. Selon la présente invention, ces procédés de fabrication d'une structure comprenant une pluralité de membranes chacune surplombant une cavité comprennent les étapes suivantes :
a) une étape de formation d'une pluralité de cavités débouchant au niveau d'une face avant d'un substrat support, les cavités présentant une profondeur et une aire dans le plan de la face avant, et étant espacées d'un espacement ;
b) une étape d'assemblage par collage direct d'un substrat donneur sur le substrat support, au niveau de leurs faces avant respectives, de manière à sceller les cavités sous vide, le collage direct étant hydrophile et impliquant un nombre donné de monocouches d'eau à une interface de contact entre le substrat donneur et le substrat support ;
c) une étape de transfert d'une couche mince issue du substrat donneur sur le substrat support, ladite couche mince composant les membranes à l'aplomb des cavités.

Une aire spécifique est autour de chaque cavité, dans le plan de l'interface de contact, ladite aire spécifique s'exprimant en fonction de la moitié de l'espacement. Le procédé de fabrication est remarquable en ce que l'aire, la profondeur de chaque cavité, et l'aire spécifique sont définies à l'étape a) pour satisfaire la relation suivante : S / A = (Pₐₜₘ x p) / (N x 10¹⁵ x k_{B} x T), avec Pₐₜₘ la pression atmosphérique, N le nombre de monocouches d'eau à l'interface de contact, k_{B} la constante de Boltzmann et T la température ambiante.

Selon des caractéristiques avantageuses de l'invention, prises seules ou selon toute combinaison réalisable :
- le nombre de monocouches d'eau est compris entre 1 et 5, plus particulièrement compris entre 1 et 3 ;
- chaque cavité a une forme carrée, dans le plan de la face avant du substrat support, et présente une longueur de côté, les cavités sont réparties de façon matricielle avec un espacement constant entre elles, et, l'espacement et la longueur des cavités sont reliés par la relation suivante : e / L = racine[1 + [(Pₐₜₘ x p) / (N x 10¹⁵ x k_{B} x T)]] - 1 ;
- le substrat support est formé d'au moins un matériau choisi parmi le silicium, le germanium, les composés semi-conducteurs III-V, le tantalate de lithium, le niobate de lithium et le verre,
- la couche mince est formée d'au moins un matériau choisi parmi le silicium, le germanium, les composés semi-conducteurs III-V, le tantalate de lithium et le niobate de lithium,
- au moins un parmi le substrat support et la couche mince de la structure comprend un matériau, le long de l'interface de contact, qui s'oxyde en présence de molécules d'eau ;
- l'étape c) de transfert est basée sur la création d'un plan fragile enterré dans le substrat donneur, préalablement à l'étape b) d'assemblage, et sur l'application d'un traitement thermique au cours de l'étape c) pour développer des microfissures dans le plan fragile enterré et aboutir à une séparation le long dudit.

Selon l'invention, le procédé de la revendication 6 comprend une séquence préparatoire, préalable à l'étape a), dans le cas où le nombre de monocouches d'eau impliquées dans le collage direct de l'étape b) n'est pas connu, ladite séquence préparatoire comprenant :
∘ la formation d'une pluralité de cavités débouchant au niveau d'une face avant d'un substrat support de test, les cavités présentant la profondeur et des dimensions latérales, et étant espacées d'un espacement test ;
∘ l'assemblage par collage direct d'un substrat donneur sur le substrat support de test, au niveau de leurs faces avant respectives, de manière à sceller les cavités sous vide, le collage direct étant hydrophile et impliquant un nombre donné de monocouches d'eau à une interface de contact entre le substrat donneur et le substrat support de test ;
∘ le transfert d'une couche mince issue du substrat donneur sur le substrat support de test, pour former une structure test ;
∘ la mesure d'une déformation moyenne, selon un axe normal au plan de la face avant du substrat support de test, d'une pluralité de membranes de la structure test ;
∘ la détermination de l'espacement entre les cavités à appliquer à l'étape a), en fonction de l'espacement test, des dimensions latérales des cavités, de la déformation moyenne des membranes, de la profondeur des cavités et de l'épaisseur de la couche mince.

### BREVE DESCRIPTION DES DESSINS

D'autres caractéristiques et avantages de l'invention ressortiront de la description détaillée qui va suivre en référence aux figures annexées sur lesquelles :

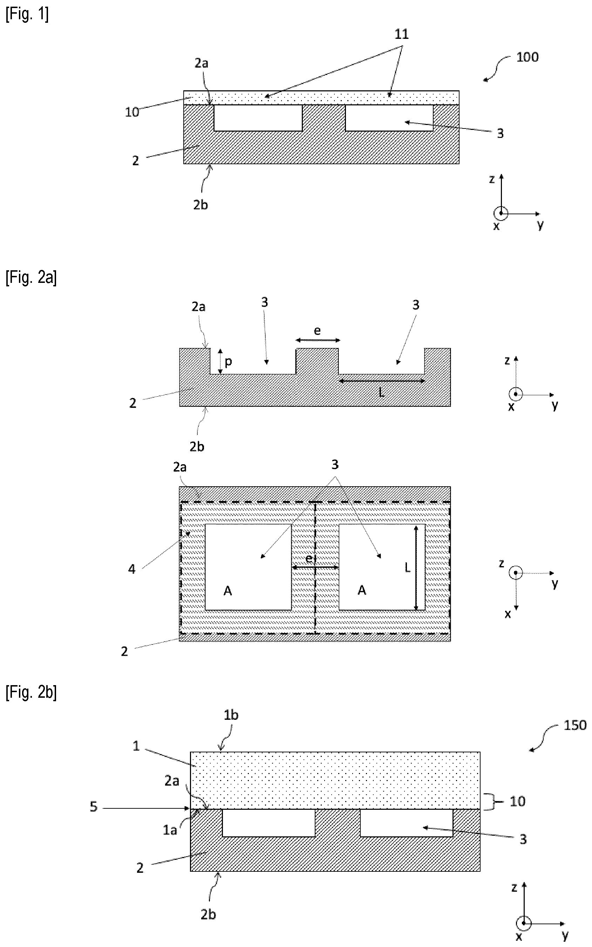

[Fig. 1] La figure 1 présente une structure élaborée selon le procédé de fabrication conforme à la présente invention ;
[Fig. 2a]
[Fig. 2b]
[Fig. 2c] Les figures 2a, 2b, 2c présentent des étapes du procédé de fabrication conforme à la présente invention ; la figure 2a propose une vue en coupe et une vue de dessus ;
[Fig. 3] La figure 3 présente un schéma d'une membrane déformée au-dessus d'une cavité dans une structure test mise en œuvre dans le procédé de fabrication conforme à l'invention ;
[Fig. 4] La figure 4 présente un graphe reliant l'espacement entre les cavités et la déflection moyenne obtenue, pour des cavités carrées de dimension latérale (25 µm) et de profondeur (350nm) fixe, élaborées dans des conditions similaires de collage (sous vide 5.10⁻³ mbar), avec une membrane en silicium d'épaisseur 1,4µm.

Certaines figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y.

Les mêmes références sur les figures pourront être utilisées pour des éléments de même nature.

### DESCRIPTION DETAILLEE DE L'INVENTION

L'invention concerne un procédé de fabrication d'une structure 100 comprenant une pluralité de membranes 11, chacune surplombant une cavité 3 (figure 1).

Le procédé de fabrication comprend en premier lieu une étape a) de formation d'une pluralité de cavités 3 débouchant au niveau d'une face avant 2a d'un substrat support 2 (Figure 2a).

Le substrat support 2 a avantageusement la forme d'une plaquette, de diamètre supérieur à 100mm, par exemple 150mm, 200mm ou 300mm, et présente une face avant 2a et une face arrière 2b. Son épaisseur est typiquement comprise entre 200 et 900 microns. Le substrat support 2 peut être formé d'au moins un matériau choisi parmi le silicium, le germanium, les composés semi-conducteurs III-V, le tantalate de lithium, le niobate de lithium, le verre, ou autre matériau d'intérêt pour l'application visée.

Comme cela est bien connu en soi, il existe différentes méthodes pour former des cavités 3 à la surface d'un substrat ; elles peuvent notamment impliquer des techniques de lithographie (pour définir la répartition et la forme des cavités 3, dans le plan (x,y) de la face avant 2a) et de gravure (pour graver localement le substrat support 2, dans les zones définies pour les cavités 3, sur une profondeur donnée).

Chaque cavité 3 présente une profondeur p pouvant typiquement varier entre 100nm et 100µm. Sa forme, dans le plan (x,y) de la face avant 2a, peut être circulaire, carrée, rectangulaire ou polygonale. La ou les dimension(s) caractéristique(s) (ou dimension(s) latérale(s)) d'une cavité 3 dans le plan (x,y), à savoir son diamètre (pour une forme circulaire) ou son côté L (pour une forme carrée) ou encore sa largeur et sa longueur (pour une forme rectangulaire), est(sont) typiquement comprise(s) entre 1µm et 500µm. L'aire A (dans le plan (x,y)) d'une cavité 3 est donc typiquement comprise entre 1 µm² et 0,25 mm².

Les cavités 3 sont espacées entre elles d'un espacement noté e. Cet espacement peut être compris entre 1µm et quelques centaines de mm, par exemple 500µm. Même si cela n'est pas illustré sur les figures, notons que les cavités 3 pourraient être séparées d'un espacement différent selon l'axe x et selon l'axe y.

On définit une zone de contour 4, autour de chaque cavité 3, dans le plan (x,y) de la face avant 2a du substrat support 2 (zones délimitées par des pointillés sur la figure 2a). Chaque zone de contour 4 entoure une cavité 3 et est adjacente mais disjointe des zones de contour 4 entourant les cavités 3 voisines. L'ensemble des zones de contour 4 correspond à la surface dépourvue de cavités 3 de la face avant 2a du substrat support 2.

L'aire d'une zone de contour 4 est appelée aire spécifique S ; elle s'exprime en fonction de la moitié de l'espacement e entre des cavités 3 voisines. Dans l'exemple de la figure 2a (cavités 3 de forme carrée), la surface spécifique s'exprime en fonction de l'espacement e entre les cavités 3 et de la longueur L de côté des cavités 3 comme suit : $S = {e}^{2} + \left(2L\times e\right)$

Cette aire spécifique S pourra bien sûr s'exprimer différemment selon la forme des cavités 3 et leur répartition. Dans tous les cas, elle peut s'exprimer en fonction de la moitié de l'espacement e et des dimensions latérales de la cavité 3.

La face avant 2a du substrat support 2 est destinée à être assemblée contre une face avant 1a d'un substrat donneur 1.

Comme le substrat support 2, le substrat donneur 1 a avantageusement la forme d'une plaquette, de diamètre supérieur à 100mm, par exemple 150mm, 200mm ou 300mm, et présente une face avant 1a et une face arrière 1b. Son épaisseur est typiquement comprise entre 200 et 900 microns. Le substrat donneur 1 peut être formé d'au moins un matériau choisi parmi le silicium, le germanium, les composés semi-conducteurs III-V, le tantalate de lithium, le niobate de lithium, ou autre matériau d'intérêt pour former les membranes 11 à l'aplomb des cavités 3. En effet, le substrat donneur 1 est destiné à fournir une couche mince 10, qui, transférée sur le substrat support 2, formera la pluralité de membranes 11 surplombant les cavités 3.

Le procédé de fabrication selon l'invention comprend ensuite une étape b) d'assemblage par collage direct du substrat donneur 1 sur le substrat support 2, au niveau de leurs faces avant 1a, 2a respectives, de manière à sceller les cavités 3 et à former une structure collée 150 (figure 2b).

Le principe du collage direct, bien connu dans l'état de l'art, ne sera pas décrit plus en détail ici. Parce qu'il est basé sur une adhésion moléculaire entre des faces assemblées, un très bon état de surface (propreté, faible rugosité, ...) des substrats 1,2 est requis, pour obtenir une bonne qualité d'assemblage.

Préalablement à l'assemblage, une préparation des substrats donneur 1 et support 2, est habituellement réalisée. A titre d'exemple, une séquence classique utilisée en microélectronique, notamment pour des substrats à base de silicium, comprend un nettoyage à l'ozone, un nettoyage de type SC1 (« Standard Clean 1 ») et un nettoyage de type SC2 (« Standard Clean 2 »), avec des rinçages intercalés. Une activation des surfaces à assembler, par exemple par plasma, pourra également être effectuée avant la mise en contact, pour favoriser une forte énergie de collage entre lesdites surfaces.

Optionnellement, le substrat donneur 1 et/ou le substrat support 2 peuvent comprendre une couche intermédiaire, au niveau de leurs faces avant 1a,2a respectives, pour favoriser la qualité de collage et l'énergie de collage de leur interface. Cette couche intermédiaire peut notamment être formée en oxyde de silicium. Dans le cas particulier où le substrat donneur 1 et le substrat support 2 sont en silicium, la structure 100 obtenue à l'issue du procédé est une structure SOI (silicium sur isolant) avec cavités 3 enterrées.

Le collage direct de l'étape b) est opéré dans une enceinte sous basse pression, de manière à sceller les cavités 3 sous vide, typiquement avec une pression inférieure à 1 mbar. Avantageusement, la pression dans les cavités 3 est de l'ordre de 5.10⁻³ mbar.

En outre, le collage direct de l'étape b) est de type hydrophile, c'est-à-dire qu'il implique un nombre donné (N) de monocouches d'eau à une interface de contact 5 entre le substrat donneur 1 et le substrat support 2. En fonction des préparations de surface avant l'assemblage, des matériaux mis en contact (matériaux composant le substrat donneur 1 et le substrat support 2) ainsi que de l'atmosphère de collage, le nombre de monocouches d'eau à l'interface de contact 5 peut varier, typiquement entre 1 et 5.

A titre d'exemple, dans le cas d'un substrat support 2 en silicium assemblé à un substrat donneur 1 en silicium muni sur sa face avant 1a d'une couche intermédiaire en oxyde de silicium, via un collage direct hydrophile, dans une enceinte à 5.10⁻³ mbar, le nombre de monocouches d'eau à l'interface de contact 5 est compris entre 1 et 3.

Notons que le nombre de monocouches d'eau à la surface des substrats 1,2 peut être évalué par réflexion de rayons X, par exemple dans une infrastructure de type ESRF.

Comme évoqué précédemment, l'ensemble des zones de contour 4 correspond à la surface dépourvue de cavités 3 de la face avant 2a du substrat support 2 : l'ensemble des zones de contour 4 est donc assemblé avec la face avant 1a du substrat donneur 1 pour former l'interface de contact 5 de la structure collée 150.

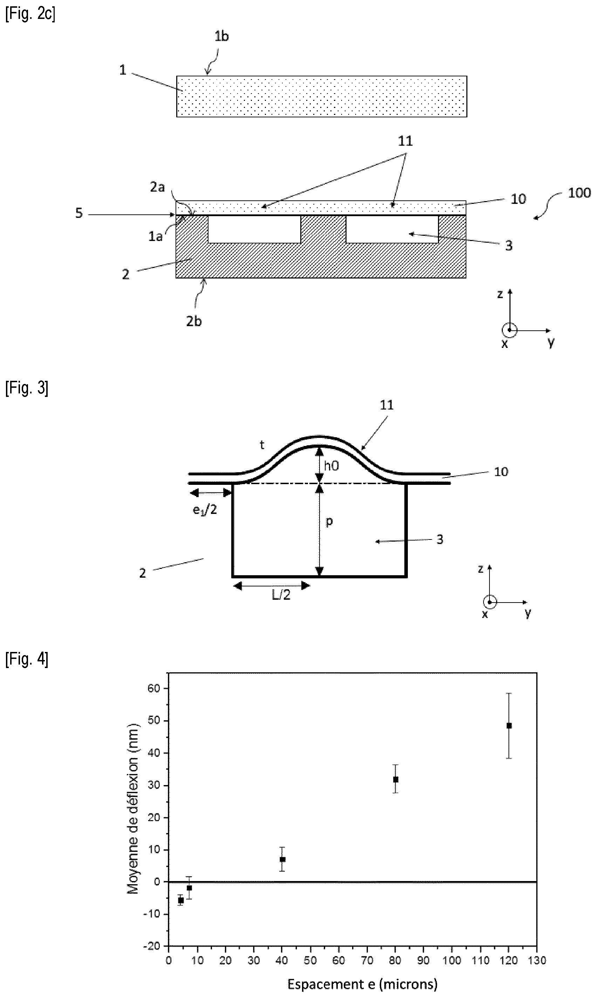

Le procédé de fabrication selon l'invention comprend enfin une étape c) de transfert d'une couche mince 10, issue du substrat donneur 1, sur le substrat support 2 : ladite couche mince 10 compose les membranes à l'aplomb des cavités (figure 2c).

L'étape c) de transfert peut être réalisée par toute technique connue de transfert de couche mince (10). Préférentiellement, l'étape c) de transfert est basée sur la création d'un plan fragile enterré dans le substrat donneur 1, préalablement à l'étape b) d'assemblage. Un tel plan fragile enterré est typiquement formé par implantation d'espèces légères (notamment hydrogène et/ou hélium, ou autres espèces), lesquelles induisent des défauts de type microcavités (ou « platelets » du fait de leur forme habituellement lenticulaire), en particulier à proximité du pic de concentration maximale : cette région enterrée de microcavités est nommée plan fragile enterré par simplification. L'étape c) comprend alors l'application d'un traitement thermique pour faire croitre les microcavités et développer des microfissures dans le plan fragile enterré, de manière à aboutir à une séparation le long dudit plan. Cette technique fait référence au procédé Smart Cut^{™}, bien connu pour le transfert d'une couche mince monocristalline d'un substrat donneur 1 sur un substrat support 2, et ne sera pas décrite plus en détail ici.

Notons que des étapes de finition et/ou de lissage (mécaniques, mécano-chimiques, chimiques ou thermiques) de la surface libre de la couche mince 10 après transfert peuvent être implémentées pour atteindre la qualité cristalline et de surface requise pour la couche mince 10.

La présente invention s'applique aux cas où au moins un parmi les substrats donneur 1 et support 2 comprend un matériau, au niveau de l'interface de contact 5, qui s'oxyde en présence de molécules d'eau (H₂0). Ainsi, au cours du (ou des) différent(s) traitement(s) thermique(s) appliqué(s) à la structure collée 150, soit pour renforcer l'énergie de collage de l'interface de contact 5, soit pour effectuer l'étape c) ou une étape encore ultérieure du procédé, une réaction d'oxydation dudit matériau s'opère et aboutit à la formation de molécules de dihydrogène gazeux.

Dans l'exemple particulier d'une interface de contact 5 faisant intervenir du silicium, la réaction d'oxydation s'écrit comme suit : Si + 2H₂O -> SiO₂ + 2H₂.

La demanderesse a mis en évidence que le gaz H₂ est produit au niveau de l'interface de contact 5 et est capable de diffuser et de venir remplir les cavités 3. La présence de ce gaz provoque donc une montée en pression dans le volume de la cavité 3 scellée, susceptible d'induire une déformation de la membrane 11 lorsque celle-ci sera formée et subira la pression atmosphérique Pₐₜₘ sur sa face supérieure.

A titre d'exemple, le graphe de la figure 4 montre l'évolution de la déflexion moyenne de la membrane 11, en fonction de l'espacement e entre des cavités 3 carrées de 25µm de côté, avec une épaisseur de membrane (silicium) de 1,4µm, et dans des conditions de collage données. On voit expérimentalement qu'il existe une condition d'espacement pour laquelle la déformation de la membrane est nulle, ou tout au moins, très réduite.

L'invention vise justement à minimiser cette déformation, en établissant des règles de conception liant les conditions de collage, les dimensions des cavités 3 et leur répartition sur le substrat support 2.

Pour cela, l'aire A, la profondeur p de chaque cavité 3, et l'aire spécifique S des zones de contour 4 sont définies à l'étape a) du procédé, pour satisfaire la relation suivante : $\frac{S}{A} = \frac{{P}_{atm} \times p}{N \times {10}^{15} \times {k}_{B} \times T}$ avec Pₐₜₘ la pression atmosphérique (10⁵ Pa), p la profondeur de chaque cavité, N le nombre de monocouches d'eau à l'interface de contact 5, k_{B} la constante de Boltzmann (1,38.10⁻²³ J/K) et T la température ambiante (300K).

L'étape b) d'assemblage par collage direct définit le nombre N de monocouches d'eau qui seront présentes à l'interface de contact 5. Il a été établi par la demanderesse que la quantité estimée n_{H2} de molécules de gaz H₂ produites à l'interface de contact 5 et diffusant dans chaque cavité 3 est liée à l'aire spécifique S et au nombre de monocouches N selon la relation suivante : ${n}_{H 2} = S \times N \times {10}^{15}$

En injectant cette relation Equ.3 dans la loi des gaz parfaits, on obtient la relation Equ.2 précitée, qui définit les règles de conception liant conditions de collage, dimensions et répartition des cavités 3. En d'autres termes, l'aire A (dimensions latérales), la profondeur p des cavités 3 et l'espacement e entre les cavités 3 peuvent être définis à partir de la relation Equ.2, de manière à minimiser la déformation de la membrane 11, à l'issue du procédé de l'étape c).

Dans le cas particulier de cavités 3 de forme carrée (dans le plan (x,y) de la face avant 2a du substrat support 2), présentant une longueur de côté L et réparties de façon matricielle avec un espacement e constant entre elles, on peut établir la relation suivante : $\frac{e}{L} = \sqrt{1 + \frac{{P}_{atm} \times p}{N \times {10}^{15} \times {k}_{B} \times T}} - 1$ avec Pₐₜₘ la pression atmosphérique, p la profondeur de chaque cavité 3, N le nombre de monocouches d'eau à l'interface de contact 5, k_{B} la constante de Boltzmann et T la température ambiante.

Cette équation peut permettre d'élaborer des abaques reliant l'espacement e et la longueur de côté L, pour des cavités carrées présentant différentes profondeurs p et pour un nombre de monocouches d'eau pouvant varier entre 1 et 5. Ces abaques donnent des règles de conception, pour des conditions de collage données, permettant de minimiser la déflection de la membrane 11 à l'aplomb des cavités 3.

Selon une variante, le procédé de fabrication comprend une séquence préparatoire, préalable à l'étape a), s'appliquant dans le cas où le nombre N de monocouches d'eau impliquées dans le collage direct de l'étape b) n'est pas connu.

La séquence préparatoire comprend en premier lieu la formation d'une pluralité de cavités débouchant au niveau d'une face avant d'un substrat support de test ; ces cavités présentent une profondeur p et des dimensions latérales (longueur de côté L, dans le cas de cavités carrées), et sont espacées d'un espacement test e₁.

La séquence préparatoire comprend ensuite l'assemblage par collage direct d'un substrat donneur 1 sur le substrat support de test, au niveau de leurs faces avant respectives, de manière à sceller les cavités sous vide, le collage direct étant hydrophile et impliquant un nombre donné N de monocouches d'eau à l'interface de contact entre le substrat donneur 1 et le substrat support de test.

Puis, le transfert d'une couche mince 10 issue du substrat donneur 1 sur le substrat support de test est effectué, pour former une structure test.

La séquence préparatoire prévoit ensuite la mesure d'une déformation h₀ moyenne, selon un axe z normal au plan (x,y) de la face avant du substrat support de test, d'une pluralité de membranes 11 de la structure test (figure 3). A partir de ces mesures, il est déterminé la différence de pression entre intérieur et extérieur de la cavité 3, ce qui permet de remonter à la quantité de gaz H₂ produite, dans les conditions de collage utilisées.

En considérant que la membrane 11 est encastrée sur les bords de la cavité 3, la relation entre la déflection maximale h₀, et la différence de pression ΔP et la dimension latérale L de la membrane 11 s'écrit : ${h}_{0} = \frac{3}{64} \left(1-{ν}^{2}\right) \frac{Δ {PL}^{4}}{E {t}^{3}}$

Avec t l'épaisseur de la membrane 11 (et de la couche mince 10), E et v, respectivement le module d'Young et le coefficient de Poisson de la couche mince 10.

La relation Equ.5 peut également s'écrire comme : $Δ P = E \frac{64 {t}^{3} {h}_{0}}{3 \left(1-{ν}^{2}\right) {L}^{4}}$

En négligeant le changement de volume associé à la déformation de la membrane 11, on peut écrire la relation suivante entre la quantité n'_{H2} de gaz dans la cavité et la pression sous la forme : $\left({P}_{atm}+ΔP\right) \times A \times p = n {′}_{H 2} \times {k}_{B} \times T = N \times {10}^{15} \times \left({{e}_{1}}^{2}+2L.{e}_{1}\right) \times {k}_{B} \times T$

Avec A l'aire de la cavité, L sa dimension latérale, p sa profondeur, e₁ l'espacement test entre les cavités.

Cette même expression, pour une membrane 11 non déformée visée, avec un espacement e entre les cavités 3, donne : $\left({P}_{atm}\right) \times A \times p = {n}_{H 2} \times {k}_{B} \times T = N \times {10}^{15} \times \left({e}^{2}+2L.e\right) \times {k}_{B} \times T$

Le rapport entre les deux expressions Equ.7 et Equ.6 mène à établir une relation intermédiaire Equ.8', aboutissant à une relation Equ.8 entre l'espacement e visé pour minimiser la déformation des membranes 11, dans les conditions de collage testées, avec les dimensions (L, p) des cavités 3 également testées et les caractéristiques de la couche mince 10 transférée : $\frac{{e}^{2} + 2 L . e}{{{e}_{1}}^{2} + 2 L . {e}_{1}} = \frac{{P}_{atm}}{\left({P}_{atm}+ΔP\right)} = \frac{1}{1 + \frac{E 64 {t}^{3} {h}_{0}}{{P}_{atm} 3 \left(1-{ν}^{2}\right) {L}^{4}}}$ $e = L \times \left(-1+\sqrt{1 + \frac{1}{1 + \frac{E 64 {t}^{3} {h}_{0}}{{P}_{atm} 3 \left(1-{ν}^{2}\right) {L}^{4}}} \times \left(\frac{{{e}_{1}}^{2}}{{L}^{2}}+\frac{2 {e}_{1}}{L}\right)}\right)$

La séquence préparatoire permet donc d'identifier l'espacement e entre les cavités 3, à appliquer à l'étape a), qui permettra une déformation minimale des membranes 11 après transfert, dans les conditions de collage et avec les caractéristiques physiques (épaisseur et nature de la couche mince 10) et dimensionnelles (taille latérale et profondeur des cavités) testées.

La séquence préparatoire a été décrite dans le cas de cavités de forme carrée. Les relations Equ.5 à Equ.8 pourraient bien sûr être adaptées pour prendre en compte une forme différente, qui se traduirait en particulier par une expression ajustée de l'aire A des cavités et de l'aire spécifique S des zones de contour 4.

La présente invention peut être mise à profit pour une large gamme de dispositifs MEMS ou NEMS (« Nanoelectromechanical systems »), ou pour toute autre application nécessitant la réalisation de membranes suspendues à très faible déflection.

L'invention n'est pas limitée aux modes de réalisation décrits et on peut y apporter des variantes de réalisation sans sortir du cadre de l'invention tel que défini par les revendications.

## Revendications

1. Procédé de fabrication d'une structure (100) comprenant une pluralité de membranes (11) chacune surplombant une cavité (3), le procédé de fabrication comprenant les étapes suivantes :
a) une étape de formation d'une pluralité de cavités (3) débouchant au niveau d'une face avant (2a) d'un substrat support (2), les cavités (3) présentant une profondeur (p) et une aire (A) dans le plan (x,y) de la face avant (2a), et étant espacées d'un espacement (e), une zone de contour (4) étant définie autour de chaque cavité (3), dans le plan (x,y) de la face avant (2a), chaque zone de contour (4) entourant une cavité (3) et étant adjacente mais disjointe des zones de contour (4) entourant les cavités (3) voisines, l'ensemble des zones de contour (4) correspondant à la surface dépourvue de cavités (3) de la face avant (2a) du substrat support (2) ;
b) une étape d'assemblage par collage direct d'un substrat donneur (1) sur le substrat support (2), au niveau de leurs faces avant respectives (1a,2a), de manière à sceller les cavités (3) sous vide, le collage direct étant hydrophile et impliquant un nombre donné (N) de monocouches d'eau à une interface de contact (5) entre le substrat donneur (1) et le substrat support (2) ;
c) une étape de transfert d'une couche mince (10) issue du substrat donneur (1) sur le substrat support (2), ladite couche mince (10) composant les membranes (11) à l'aplomb des cavités (3) ; le procédé de fabrication étant **caractérisé en ce que** :
- étant défini que chaque zone de contour (4) présente une aire appelée aire spécifique (S) autour de chaque cavité (3), dans le plan de l'interface de contact (5), ladite aire spécifique (S) s'exprimant en fonction de la moitié de l'espacement (e),
- l'aire (A), la profondeur (p) de chaque cavité, et l'aire spécifique (S) sont définies à l'étape a) pour satisfaire la relation suivante : S / A = (Pₐₜₘ x p) / (N x 10¹⁵ x k_{B} x T), avec Pₐₜₘ la pression atmosphérique, N le nombre de monocouches d'eau à l'interface de contact, k_{B} la constante de Boltzmann et T la température ambiante.

2. Procédé de fabrication selon la revendication précédente, dans lequel le nombre (N) de monocouches d'eau est compris entre 1 et 5, plus particulièrement compris entre 1 et 3.

3. Procédé de fabrication selon l'une des revendications précédentes, dans lequel:
- chaque cavité (3) a une forme carrée dans le plan (x,y) de la face avant (2a) du substrat support (2), présentant une longueur de côté (L) et les cavités (3) sont réparties de façon matricielle avec un espacement (e) constant entre elles,
- l'espacement (e) et la longueur (L) des cavités sont reliés par la relation suivante : e / L = racine[1 + [(Pₐₜₘ x p) / (N x 10¹⁵ x k_{B} x T)]] - 1.

4. Procédé de fabrication selon l'une des revendications précédentes, dans lequel:
- le substrat support (2) est formé d'au moins un matériau choisi parmi le silicium, le germanium, les composés semi-conducteurs III-V, le tantalate de lithium, le niobate de lithium et le verre,
- la couche mince (10) est formée d'au moins un matériau choisi parmi le silicium, le germanium, les composés semi-conducteurs III-V, le tantalate de lithium et le niobate de lithium, et
- au moins un parmi le substrat support (2) et la couche mince (10) de la structure (100) comprend un matériau, le long de l'interface de contact (5), qui s'oxyde en présence de molécules d'eau.

5. Procédé de fabrication selon l'une des revendications précédentes, dans lequel l'étape c) de transfert est basée sur :
- la création d'un plan fragile enterré dans le substrat donneur (1), préalablement à l'étape b) d'assemblage, et
- l'application d'un traitement thermique au cours de l'étape c) pour développer des microfissures dans le plan fragile enterré et aboutir à une séparation le long dudit plan.

6. Procédé de fabrication d'une structure (100) comprenant une pluralité de membranes (11) chacune surplombant une cavité (3), le procédé de fabrication comprenant les étapes suivantes :
a) une étape de formation d'une pluralité de cavités (3) débouchant au niveau d'une face avant (2a) d'un substrat support (2), les cavités (3) présentant une profondeur (p) et une aire (A) dans le plan (x,y) de la face avant (2a), et étant espacées d'un espacement (e) ;
b) une étape d'assemblage par collage direct d'un substrat donneur (1) sur le substrat support (2), au niveau de leurs faces avant respectives (1a,2a), de manière à sceller les cavités (3) sous vide, le collage direct étant hydrophile et impliquant un nombre donné (N) de monocouches d'eau à une interface de contact (5) entre le substrat donneur (1) et le substrat support (2) ;
c) une étape de transfert d'une couche mince (10) issue du substrat donneur (1) sur le substrat support (2), ladite couche mince (10) composant les membranes (11) à l'aplomb des cavités (3) ; le procédé de fabrication étant **caractérisé en ce qu'**il comprend une séquence préparatoire, préalable à l'étape a), dans le cas où le nombre de monocouches d'eau (N) impliquées dans le collage direct de l'étape b) n'est pas connu, ladite séquence préparatoire comprenant :
- la formation d'une pluralité de cavités débouchant au niveau d'une face avant d'un substrat support de test, les cavités présentant la profondeur (p) et des dimensions latérales (L), et étant espacées d'un espacement test (e1) ;
- l'assemblage par collage direct d'un substrat donneur (1) sur le substrat support de test, au niveau de leurs faces avant respectives, de manière à sceller les cavités sous vide, le collage direct étant hydrophile et impliquant un nombre donné (N) de monocouches d'eau à une interface de contact entre le substrat donneur (1) et le substrat support de test ;
- le transfert d'une couche mince (10) issue du substrat donneur (1) sur le substrat support de test, pour former une structure test ;
- la mesure d'une déformation moyenne (h₀), selon un axe (z) normal au plan (x,y) de la face avant du substrat support de test, d'une pluralité de membranes (11) de la structure test ;
- la détermination de l'espacement (e) entre les cavités à appliquer à l'étape a), en fonction de l'espacement test (e1), des dimensions latérales (L) des cavités, de la déformation (h₀) moyenne des membranes (11), de la profondeur (p) des cavités et de l'épaisseur de la couche mince (10).

## Patentansprüche

1. Verfahren zur Herstellung einer Struktur (100), die eine Vielzahl von Membranen (11) umfasst, von denen jede über einen Hohlraum (3) vorspringt, wobei das Herstellungsverfahren die folgenden Schritte umfasst:
a) einen Schritt der Bildung einer Vielzahl von Hohlräumen (3), die an einer Vorderseite (2a) eines Trägersubstrats (2) münden, wobei die Hohlräume (3) in der Ebene (x, y) der Vorderseite (2a) eine Tiefe (p) und eine Fläche (A) aufweisen und in einem Abstand (e) voneinander angeordnet sind, wobei um jeden Hohlraum (3) in der Ebene (x, y) der Vorderseite (2a) eine Konturzone (4) definiert ist, wobei jede Konturzone (4) einen Hohlraum (3) umgibt und an die Konturzonen (4) angrenzt, die die benachbarten Hohlräume (3) umgeben, jedoch von diesen getrennt ist, und wobei die Gesamtheit der Konturzonen (4) der von Hohlräumen (3) freien Fläche der Vorderseite (2a) des Trägersubstrats (2) entspricht;
b) einen Schritt des Zusammenfügens durch direktes Verkleben eines Donorsubstrats (1) mit dem Trägersubstrat (2) an deren jeweiligen Vorderseiten (1a, 2a), um die Hohlräume (3) unter Vakuum abzudichten, wobei die Direktverklebung hydrophil ist und eine bestimmte Anzahl (N) von Wassermonoschichten an einer Kontaktgrenzfläche (5) zwischen dem Donorsubstrat (1) und dem Trägersubstrat (2) umfasst;
c) einen Schritt zum Übertragen einer vom Donorsubstrat (1) stammenden dünnen Schicht (10) auf das Trägersubstrat (2), wobei die dünne Schicht (10) die Membranen (11) bildet, die senkrecht über den Hohlräume (3) liegen; wobei das Herstellungsverfahren **dadurch gekennzeichnet ist, dass**:
- definiert ist, dass jeder Konturbereich (4) in der Ebene der Kontaktfläche (5) eine als spezifische Fläche (S) bezeichnete Fläche um jeden Hohlraum (3) aufweist, wobei sich die spezifische Fläche (S) als Funktion der Hälfte des Abstands (e) ausdrückt,
- die Fläche (A), die Tiefe (p) jedes Hohlraums und die spezifische Fläche (S) in Schritt a) so definiert werden, dass sie der folgenden Beziehung genügen: S / A = (Pₐₜₘ × p) /(N × 10¹⁵ × k_{B} × T), wobei Pₐₜₘ der atmosphärische Druck, N die Anzahl der Wassermonoschichten an der Kontaktfläche, k_{B} die Boltzmann-Konstante und T die Umgebungstemperatur ist.

2. Verfahren zur Herstellung nach dem vorstehenden Anspruch, wobei die Anzahl (N) der Wassermonoschichten zwischen 1 und 5, insbesondere zwischen 1 und 3, liegt.

3. Verfahren zur Herstellung nach einem der vorstehenden Ansprüche, wobei:
- jeder Hohlraum (3) in der (x,y)-Ebene der Vorderseite (2a) des Trägersubstrats (2) eine quadratische Form mit einer Seitenlänge (L) hat, und die Hohlräume (3) in einer Matrixanordnung mit einem konstanten Abstand (e) zueinander angeordnet sind,
- Der Abstand (e) und die Länge (L) der Hohlräume in folgendem Zusammenhang stehen: e / L = Wurzel[1 +[(Pₐₜₘ × p) / (N × 10¹⁵ × k_{B} × T)]] - 1

4. Verfahren zur Herstellung nach einem der vorstehenden Ansprüche, wobei:
- das Trägersubstrat (2) aus mindestens einem Material gebildet ist, das aus Silizium, Germanium, III-V-Halbleiterverbindungen, Lithiumtantalat, Lithiumniobat und Glas ausgewählt ist,
- die dünne Schicht (10) aus mindestens einem Material gebildet ist, das aus Silizium, Germanium, III-V-Halbleiterverbindungen, Lithiumtantalat und Lithiumniobat ausgewählt ist, und
- Mindestens eines von dem Trägersubstrat (2) und der dünnen Schicht (10) der Struktur (100) entlang der Kontaktgrenzfläche (5) ein Material umfasst, das in Gegenwart von Wassermolekülen oxidiert.

5. Verfahren zur Herstellung nach einem der vorstehenden Ansprüche, wobei der Übertragungsschritt c) auf Folgendem basiert:
- die Herstellung einer vergrabenen spröden Ebene, die vor dem Schritt b) des Zusammenbaus in das Donorsubstrat (1) eingebettet wird, und
- die Durchführung einer Wärmebehandlung während des Schritts c), um Mikrorisse in der vergrabenen spröden Ebene zu erzeugen und eine Trennung entlang dieser Fläche zu bewirken.

6. Verfahren zur Herstellung einer Struktur (100), die eine Vielzahl von Membranen (11) umfasst, von denen jede über einem Hohlraum (3) vorspringt, wobei das Herstellungsverfahren die folgenden Schritte umfasst:
a) einen Schritt zum Ausbilden einer Vielzahl von Hohlräumen (3), die an einer Vorderseite (2a) eines Trägersubstrats (2) münden, wobei die Hohlräume (3) eine Tiefe (p) und eine Fläche (A) in der Ebene (x, y) der Vorderseite (2a) aufweisen und in einem Abstand (e) voneinander angeordnet sind;
b) einen Schritt des Zusammenfügens durch direktes Verkleben eines Donorsubstrats (1) mit dem Trägersubstrat (2) an deren jeweiligen Vorderseiten (1a, 2a), um die Hohlräume (3) unter Vakuum abzudichten, wobei die Direktverklebung hydrophil ist und eine bestimmte Anzahl (N) von Wassermonoschichten an einer Kontaktgrenzfläche (5) zwischen dem Donorsubstrat (1) und dem Trägersubstrat (2) umfasst;
c) einen Schritt zum Übertragen einer vom Donorsubstrat (1) stammenden dünnen Schicht (10) auf das Trägersubstrat (2), wobei die dünne Schicht (10) die Membranen (11) senkrecht über den Hohlräumen (3) bildet; wobei das Herstellungsverfahren **dadurch gekennzeichnet ist, dass** es eine vorbereitende Sequenz umfasst, die dem Schritt a) vorausgeht, falls die Anzahl der Wassermonolagen (N), die an der direkten Verklebung des Schritts b) beteiligt sind, nicht bekannt ist, wobei die vorbereitende Sequenz umfasst:
- die Bildung einer Vielzahl von Hohlräumen, die an einer Vorderseite eines Testträgersubstrats münden, wobei die Hohlräume die Tiefe (p) und seitliche Abmessungen (L) aufweisen und in einem Testabstand (e1) voneinander angeordnet sind;
- das direkte Verkleben eines Donorsubstrats (1) auf das Testträgersubstrat an deren jeweiligen Vorderseiten, um die Vakuumkammern abzudichten, wobei die direkte Verklebung hydrophil ist und eine bestimmte Anzahl (N) von Wassermonoschichten an einer Kontaktgrenzfläche zwischen dem Donorsubstrat (1) und dem Testträgersubstrat beinhaltet;
- die Übertragung einer dünnen Schicht (10) vom Donorsubstrat (1) auf das Testträgersubstrat, um eine Teststruktur zu bilden;
- die Messung einer mittleren Verformung (h₀) entlang einer Achse (z), die senkrecht zur Ebene (x, y) der Vorderseite des Testträgersubstrats verläuft, bei einer Vielzahl von Membranen (11) der Teststruktur;
- die Bestimmung des Abstands (e) zwischen den Hohlräumen, der in Schritt a) anzuwenden ist, in Abhängigkeit vom Testabstand (e1), den seitlichen Abmessungen (L) der Hohlräume, der Verformung (h₀) der Membranen (11), der Tiefe (p) der Hohlräume und der Dicke der dünnen Schicht (10).

## Claims

1. Method for manufacturing a structure (100) comprising a plurality of membranes (11), each overhanging a cavity (3), the manufacturing method comprising the following steps:
a) a step of forming a plurality of cavities (3) opening onto a front face (2a) of a support substrate (2), the cavities (3) having a depth (p) and an area (A) in the plane (x,y) of the front face (2a), and being spaced apart by a spacing (e), a contour zone (4) being defined around each cavity (3), in the plane (x,y) of the front face (2a), each contour zone (4) surrounding a cavity (3) and being adjacent, but separated from the contour zones (4) surrounding the neighbouring cavities (3), all of the contour zones (4) corresponding to the surface devoid of cavities (3) of the front face (2a) of the support substrate (2);
b) a step of assembling by direct bonding of a donor substrate (1) on the support substrate (2), at their respective front faces (1a, 2a), so as to seal the cavities (3) under vacuum, the direct bonding being hydrophilic and involving a given number (N) of water monolayers at a contact interface (5) between the donor substrate (1) and the support substrate (2);
c) a step of transferring a thin layer (10) from the donor substrate (1) on the support substrate (2), said thin layer (10) composing the membranes (11) in vertical alignment with the cavities (3); the manufacturing method being **characterised in that**:
- being defined that each contour zone (4) has an area called specific area (S) around each cavity (3), in the plane of the contact interface (5), said specific area (S) being expressed as a function of half of the spacing (e),
- the area (A), the depth (p) of each cavity, and the specific area (S) are defined in step a) to satisfy the following relationship: S / A = (Pₐₜₘ × p) /(N × 10¹⁵ × k_{B} × T), with Pₐₜₘ the atmospheric pressure, N the number of water monolayers at the contact interface, k_{B} the Boltzmann constant and T the ambient temperature.

2. Manufacturing method according to the preceding claim, wherein the number (N) of water monolayers is comprised between 1 and 5, more specifically, comprised between 1 and 3.

3. Manufacturing method according to any one of the preceding claims, wherein:
- each cavity (3) has a square shape in the plane (x,y) of the front face (2a) of the support substrate (2), having a side length (L) and the cavities (3) are distributed in a matrix, with a constant spacing (e) between them,
- the spacing (e) and the length (L) of the cavities are connected by the following relationship: e / L = root[1 +[(Pₐₜₘ × p) / (N × 10¹⁵ × k_{B} × T)]] - 1

4. Manufacturing method according to any one of the preceding claims, wherein:
- the support substrate (2) is formed of at least one material chosen from among silicon, germanium, III-V semiconductor compounds, lithium tantalum, lithium niobate and glass,
- the thin layer (10) is formed of at least one material chosen from among silicon, germanium, III-V semiconductor compounds, lithium tantalum and lithium niobate, and
- at least one from among the support substrate (2) and the thin layer (10) of the structure (100) comprises a material, along the contact interface (5), which is oxidised in the presence of water molecules.

5. Manufacturing method according to any one of the preceding claims, wherein the transfer step c) is based on:
- the creation of a fragile plane buried in the donor substrate (1), prior to the assembly step b), and
- the application of a heat treatment during step c) to develop microcracks in the buried fragile plane and to result in a separation along said plane.

6. Method for manufacturing a structure (100) comprising a plurality of membranes (11), each overhanging a cavity (3), the manufacturing method comprising the following steps:
a) a step of forming a plurality of cavities (3) opening onto a front face (2a) of a support substrate (2), the cavities (3) having a depth (p) and an area (A) in the plane (x,y) of the front face (2a), and being spaced apart by a spacing (e);
b) a step of assembling by direct bonding of a donor substrate (1) on the support substrate (2), at their respective front faces (1a, 2a), so as to seal the cavities (3) under vacuum, the direct bonding being hydrophilic and involving a given number (N) of water monolayers at a contact interface (5) between the donor substrate (1) and the support substrate (2);
c) a step of transferring a thin layer (10) from the donor substrate (1) on the support substrate (2), said thin layer (10) composing the membranes (11) in vertical alignment with the cavities (3); the manufacturing method being **characterised in that** it comprises a preparatory sequence, prior to step a), in the case where the number of water monolayers (N) involved in the direct bonding of step b) is not known, said preparatory sequence comprising:
- the formation of a plurality of cavities opening onto a front face of a test support substrate, the cavities having the depth (p) and lateral dimensions (L), and being spaced apart by a test spacing (e1);
- the assembly by direct bonding of a donor substrate (1) on the test support substrate, at their respective front faces, so as to seal the cavities under vacuum, the direct bonding being hydrophilic and involving a given number (N) of water monolayers at a contact interface between the donor substrate (1) and the test support substrate;
- the transfer of a thin layer (10) from the donor substrate (1) on the test support substrate, to form a test structure;
- the measuring of an average deformation (h₀), about an axis (z) normal to the plane (x,y) of the front face of the test support substrate, of a plurality of membranes (11) of the test structure;
- the determining of the spacing (e) between the cavities to be applied in step a), as a function of the test spacing (e1), of the lateral dimensions (L) of the cavities, of the average deformation (h₀) of the membranes (11), of the depth (p) of the cavities and of the thickness of the thin layer (10).
